# EUROPEAN PATENT APPLICATION

(11) **EP 1 921 684 A1**
(43) Date of publication of application: **14.05.2008**
(21) Application number: 06780869.1
(22) Date of filing: 07.07.2006
(51) Int. Cl.: H01L 31/042

(54) **SOLAR CELL MODULE AND PROCESS FOR MANUFACTURE THEREOF**

(30) Priority: 31.08.2005 JP 2005251913
(71) Applicant: SANYO ELECTRIC CO., LTD., Moriguchi-shi, Osaka 570-8677 (JP)
(72) Inventor: TSUNOMURA, Yasufumi, Kobe-shi 6512109 (JP)
(74) Representative: Calderbank, Thomas Roger
(86) International application number: PCT/JP2006/313544
(87) International publication number: WO 2007/026465

(57) **Abstract**

A solar cell module capable of suppressing reduction of the quantity of power generation while retaining adhesive strength of a laminated resin film also when exposed to environment influenced by heat, moisture, light (ultraviolet light) etc. over a long period is obtained. This solar cell module (1) comprises a plurality of solar cells (10) electrically connected with each other by a tab electrode (20), a filler (40) for sealing the plurality of solar cells (10) and a laminated resin film (30, 130, 230), arranged on at least one surface of the filler (40), in which a resin film (31, 231) consisting of PET resin, an adhesive film (32, 132, 232) consisting of a copolymer of α-olefin and an ethyleny unsaturated silane compound and a weather-resistant resin film (33, 133, 233) consisting of PVDF resin are laminated successively from the side of the solar cells (10).

## Description

### Technical Field

The present invention relates to a solar cell module and a method of manufacturing a solar cell module, and more particularly, it relates to a solar cell module comprising a resin film arranged on the surface of a filler layer sealing solar cells and a method of manufacturing a solar cell module.

### Background Art

Single-sided generation type and double-sided generation type solar cell modules are known in general, and the double-sided generation type solar cell module is capable of improving the quantity of power generation by about 30 % as compared with the single-sided generation type solar cell module under the condition of perpendicular installation. The structure of a solar cell module holding solar cells sealed with a filler between two glass plates is known as to the double-sided generation type solar cell module. This is disclosed in Japanese Patent Laying-Open No. 2003-26455, for example.

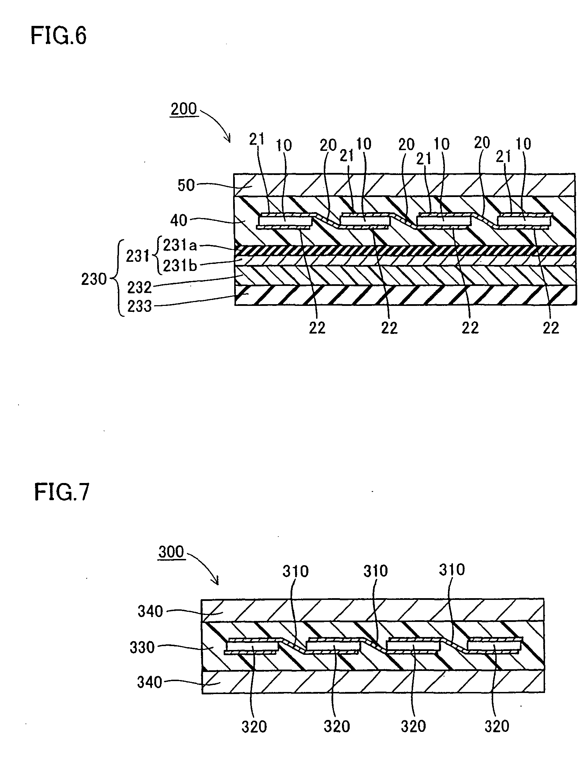

Fig. 7 is a sectional view of an exemplary conventional double-sided generation type solar cell module holding solar cells sealed with a filler between two glass plates. The conventional double-sided generation type solar cell module 300 comprises a plurality of double-incidence type solar cells 320, a filler 330 sealing the plurality of double-incidence type solar cells 320 and two surface protectors 340 consisting of glass plates arranged to hold the solar cells 320 sealed with the filler 330, as shown in Fig. 7. The exemplary conventional double-sided generation type solar cell module 300 shown in Fig. 7 holds the solar cells 320 sealed with the filler 330 between the two surface protectors 340 consisting of glass plates, whereby there has been such inconvenience that the weight increases due to the two surface protectors 340 consisting of glass and it is difficult to attain weight saving of the double-sided generation type solar cell module 300. Further, there has also been such inconvenience that the solar cells 320 are broken since the weights of the surface protectors 340 consisting of glass are applied to the solar cells 320 in a heating/pressure-bonding step in manufacturing.

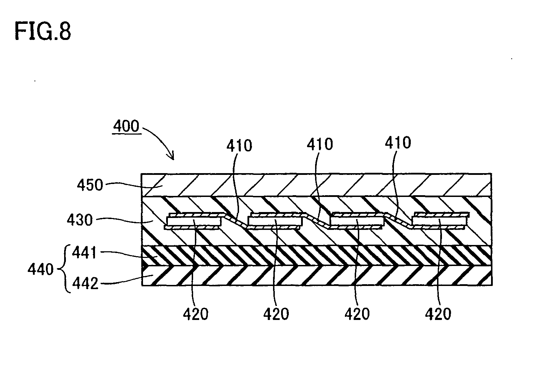

Therefore, a structure of a double-sided generation type solar cell module employing resin films lighter than glass plates as surface protectors holding solar cells sealed with a filler is proposed in general. Fig. 8 is a sectional view of an exemplary conventional double-sided generation type solar cell module employing surface protectors consisting of resin films. This double-sided generation type solar cell module 400 comprises a plurality of double-incidence type solar cells 420 connected with each other through tab electrodes 410, a filler 430 for sealing the plurality of solar cells 420, a laminated resin film (surface protector) 440 constituted of a PET (Poly Ethylene Terephthalate: polyethylene terephthalate) film 441 and a PVDF (Poly Vinylidene Fluoride: polyvinylidene fluoride) film 442 arranged on a single surface side of the filler 430 and a glass plate (surface protector) 450 arranged on another surface side of the filler 430, as shown in Fig. 8. The PET film 441 and the PVDF film 442 of the laminated resin film 440 are bonded to each other with an adhesive. In the double-sided generation type solar cell module 400 shown in Fig. 8 employing the laminated resin film 440 as one surface protector, it is possible to attain weight saving of the double-sided generation type solar cell module 400 as compared with the case of employing the two surface protectors 340 consisting of glass plates shown in Fig. 7, due to the employment of the laminated resin film 440 in place of a glass plate. Also when the weight of the laminated resin film 440 is applied to the solar cells 420 on the side of the laminated resin film 440 in a heating/pressure-bonding step in manufacturing, it is possible to suppress breakage of the solar cells 420 since the laminated resin film 440 is lighter than a glass plate.

In the conventional double-sided generation type solar cell module 440 shown in Fig. 8, however, the PET film 441 and the PVDF film 442 of the laminated resin film 440 are bonded to each other with the adhesive, whereby there has been such inconvenience that there is a possibility that the adhesive on the interface between the PET film 441 and the PVDF film 442 is discolored or deteriorated when the double-sided generation type solar cell module 440 is exposed to environment influenced by heat, moisture, light (ultraviolet light) etc. over a long period (about 20 years to about 30 years). Consequently, there has been such a problem that the quantity of sunlight incident upon the solar cells 420 decreases and the quantity of power generation of the double-sided generation type solar cell module 400 decreases when sunlight is incident upon the solar cells 420 from the side of the discolored laminated resin film 440. Further, there has also been such a problem that the adhesive on the interface between the PET film 441 and the PVDF film 442 of the laminated resin film 440 is so deteriorated that the adhesive strength of this adhesive lowers to cause peeling of the PET film 441 and the PVDF film 442.

### Disclosure of the Invention

The present invention has been proposed in order to solve the aforementioned problems, and an object of the present invention is to provide a solar cell module capable of suppressing reduction of the quantity of power generation while retaining adhesive strength of a laminated resin film also when exposed to environment influenced by heat, moisture, light (ultraviolet light) etc. over a long period and a method of manufacturing a solar cell module.

In order to attain the aforementioned object, a solar cell module according to a first aspect of the present invention comprises a plurality of solar cells electrically connected with each other, a filler layer for sealing the plurality of solar cells and a laminated resin film, arranged on at least one surface of the filler layer, in which a first resin film, an adhesive film consisting of resin containing α-olefin and an ethyleny unsaturated silane compound and a second resin film having weather resistance are laminated successively from the side of the solar cells.

In order to attain the aforementioned object, the solar cell module according to the first aspect of the present invention is provided with the laminated resin film in which the first resin film, the adhesive film consisting of resin containing α-olefin and the ethyleny unsaturated silane compound and the second resin film having weather resistance are laminated successively from the side of the solar cells as hereinabove described, whereby the adhesive film bonding the first resin film and the second resin film to each other can be inhibited from discoloring resulting from exposure to environment influenced by heat, moisture, light (ultraviolet light) etc. over a long period since the adhesive film consisting of resin containing α-olefin and the ethyleny unsaturated silane compound is less discolored or deteriorated also when the same is exposed to environment influenced by heat, moisture, light (ultraviolet light) etc. over a long period (about 20 years to about 30 years). Thus, the quantity of light incident upon the solar cells through the adhesive film can be inhibited from reduction. Consequently, the quantity of power generation of the solar cell module can be inhibited from reduction also when the solar cell module is exposed to environment influenced by heat, moisture, light (ultraviolet light) etc. over a long period. Further, the adhesive film consisting of resin containing α-olefin and the ethyleny unsaturated silane compound is so employed that the adhesive film can be inhibited from deterioration resulting from exposure to environment influenced by heat, moisture, light (ultraviolet light) etc. over a long period, whereby the adhesive strength of the adhesive film can be inhibited from reduction. Consequently, the adhesive strength of the laminated resin film of the solar cell module can be retained also when the solar cell module is exposed to environment influenced by heat, moisture, light (ultraviolet light) etc. over a long period, whereby peeling of the first resin film and the weather-resistant second resin film can be suppressed.

In the aforementioned solar cell module according to the first aspect, the adhesive film of the laminated resin film preferably contains a copolymer of the α-olefin and the ethyleny unsaturated silane compound. When employing the adhesive film consisting of resin containing α-olefin and the ethyleny unsaturated silane compound in this manner, the adhesive film can be easily inhibited from discoloring and deterioration resulting from exposure to environment influenced by heat, moisture, light (ultraviolet light) etc. over a long period, whereby the quantity of light incident upon the solar cells through the adhesive film can be easily inhibited from reduction and the adhesive strength of the adhesive film can be inhibited from reduction.

In the aforementioned solar cell module according to the first aspect, the first resin film of the laminated resin film preferably includes a substrate film and a gas barrier layer, and the gas barrier layer is preferably arranged at least on a side of the substrate film closer to the adhesive film. According to this structure, the first resin film, the filler layer and the solar cells can be inhibited from exposure to water vapor or the like with the gas barrier layer also when water vapor or the like externally infiltrates into the solar cell module. Thus, the first resin film and the filler layer can be inhibited from discoloring resulting from exposure of the first resin film and the filler layer to water vapor or the like. Consequently, the quantity of light incident upon the solar cells through the first resin film and the filler layer can be inhibited from reduction, whereby the quantity of power generation of the solar cell module can be inhibited from reduction.

In the aforementioned solar cell module according to the first aspect, the gas barrier layer preferably includes an aluminum oxide layer. According to this structure, the first resin film, the filler layer and the solar cells can be easily inhibited from exposure to water vapor or the like since the aluminum oxide layer suppresses gas permeation.

In the aforementioned solar cell module according to the first aspect, at least one of the adhesive film and the second resin film of the laminated resin film preferably contains an ultraviolet absorber. According to this structure, the first resin film arranged inside the adhesive film and the filler layer arranged inside the first resin film can be inhibited from irradiation with ultraviolet light also when ultraviolet light included in sunlight is irradiated to the laminated resin film, whereby the first resin film and the filler layer can be inhibited from discoloring with ultraviolet light. Thus, the quantity of light incident upon the solar cells from the side of the adhesive film and the weather-resistant second resin film can be inhibited from reduction. Consequently, the quantity of power generation of the solar cell module can be inhibited from reduction also when ultraviolet light is irradiated.

In the aforementioned solar cell module according to the first aspect, the solar cells are preferably of a double-incidence type. When the laminated resin film according to the aforementioned first aspect is provided on the side of at least either surfaces of the double-incidence type solar cells, the quantity of power generation can be inhibited from reduction and the adhesive strength of the laminated resin film can be retained also when the solar cell module is exposed to environment influenced by heat, moisture, light (ultraviolet light) etc. over a long period, while obtaining a solar cell module having a larger quantity of power generation as compared with a solar cell module employing single-incidence type solar cells.

In the aforementioned solar cell module according to the first aspect, the first resin film of the laminated resin film preferably contains polyethylene terephthalate (PET). According to this structure, the first resin film can be inhibited from discoloring or deterioration since the first resin film containing polyethylene terephthalate (PET) has heat resistance, an insulation property and transparency also when exposed to environment influenced by heat, moisture, light (ultraviolet light) etc. over a long period.

In the aforementioned solar cell module according to the first aspect, the second resin film, having weather resistance, of the laminated resin film preferably contains polyvinylidene fluoride (PVDF). According to this structure, the second resin film can be inhibited from discoloring or deterioration since the weather-resistant second resin film containing polyvinylidene fluoride (PVDF) has weather resistance, water resistance, light resistance, abrasion resistance and transparency also when exposed to environment influenced by heat, moisture, light (ultraviolet light) etc. over a long period.

In the aforementioned solar cell module according to the first aspect, the laminated resin film is preferably arranged on one surface of the filler layer, and a glass plate is preferably arranged on another surface of the filler layer. According to this structure, it is possible to efficiently generate power with sunlight incident from the side of the glass plate by arranging the glass plate having high light transmittance to be on the side of the sunlight while arranging the laminated resin film having smaller light transmittance than the glass plate to be on a side opposite to the side of the sunlight. Consequently, the quantity of power generation of the solar cell module can be increased as compared with a case of arranging laminated resin films on both surfaces of the filler layer sealing the solar cells.

A method of manufacturing a solar cell module according to a second aspect of the present invention comprises steps of preparing a plurality of solar cells electrically connected with each other, heat-treating a first resin film thereby previously thermally shrinking the first resin film and thereafter integrating the plurality of solar cells, a filler layer, the first resin film, an adhesive film consisting of a copolymer of α-olefin and an ethyleny unsaturated silane compound and a second resin film having weather resistance by performing heating/pressure-bonding in a laminated state.

In the method of manufacturing a solar cell module according to the second aspect of the present invention, as hereinabove described, the plurality of solar cells, the filler layer, the first resin film, the adhesive film consisting of the copolymer of α-olefin and the ethyleny unsaturated silane compound and the second resin film having weather resistance are integrated with each other by performing heating/pressure-bonding in the laminated state, whereby the adhesive film bonding the first resin film and the weather-resistant second resin film to each other can be inhibited from discoloring resulting from exposure to environment influenced by heat, moisture, light (ultraviolet light) etc. over a long period since the adhesive film consisting of the copolymer of α-olefin and the ethyleny unsaturated silane compound is less discolored or deteriorated also when the same is exposed to environment influenced by heat, moisture, light (ultraviolet light) etc. over a long period (about 20 years to about 30 years). Thus, the quantity of light incident upon the solar cells through the adhesive film can be inhibited from reduction. Consequently, the quantity of power generation of the solar cell module can be inhibited from reduction also when the solar cell module is exposed to environment influenced by heat, moisture, light (ultraviolet light) etc. over a long period. Further, the adhesive film consisting of the copolymer of α-olefin and the ethyleny unsaturated silane compound is so employed that the adhesive film can be inhibited from deterioration resulting from exposure to environment influenced by heat, moisture, light (ultraviolet light) etc. over a long period, whereby adhesive strength of the adhesive film can be inhibited from reduction. Consequently, the adhesive strength of the laminated resin film of the solar cell module can be retained also when the solar cell module is exposed to environment influenced by heat, moisture, light (ultraviolet light) etc. over a long period, whereby peeling of the first resin film and the weather-resistant second resin film can be inhibited.

According to the second aspect, further, the first resin film closest to the side of the solar cells among the first resin film, the adhesive film and the weather-resistant second resin film can be inhibited from thermal shrinkage when heating/pressure-bonding the plurality of solar cells, the filler layer, the first resin film, the adhesive film consisting of resin containing α-olefin and the ethyleny unsaturated silane compound and the weather-resistant second resin film in the laminated state by heat-treating the first resin film thereby previously thermally shrinking the first resin film. Thus, the solar cells can be inhibited from moving following thermal shrinkage of the first resin film in heating/pressure-bonding, whereby the plurality of solar cells can be inhibited from coming into contact with each other. Consequently, the solar cells can be inhibited from breakage.

In the aforementioned method of manufacturing a solar cell module according to the second aspect, the step of previously thermally shrinking the first resin film preferably includes a step of previously thermally shrinking the first resin film under a temperature condition substantially identical to a temperature condition for the step of performing integration by carrying out heating/pressure-bonding. When substantially equalizing the temperature condition for previously performing thermal shrinkage and the temperature condition for carrying out heating/pressure-bonding to each other in this manner, the first resin film thermally shrank under a prescribed temperature condition can be inhibited from thermally shrinking again in heating/pressure-bonding under a temperature condition substantially identical to the prescribed temperature condition.

In the aforementioned method of manufacturing a solar cell module according to the second aspect, the adhesive film preferably contains the copolymer of the α-olefin and the ethyleny unsaturated silane compound. When employing the adhesive film containing the copolymer of the α-olefin and the ethyleny unsaturated silane compound in this manner, the adhesive film can be easily inhibited from discoloring and deterioration resulting from exposure to environment influenced by heat, moisture, light (ultraviolet light) etc. over a long period, whereby the quantity of light incident upon the solar cells through the adhesive film can be easily inhibited from reduction and the adhesive strength of the adhesive film can be inhibited from reduction.

In the aforementioned method of manufacturing a solar cell module according to the second aspect, the first resin film preferably includes a substrate film and a gas barrier layer, and the gas barrier layer is preferably arranged at least on a side of the substrate film closer to the adhesive film. According to this structure, the first resin film, the filler layer and the solar cells can be inhibited from exposure to water vapor or the like with the gas barrier layer also when water vapor or the like externally infiltrates into the solar cell module. Thus, the first resin film and the filler layer can be inhibited from discoloring resulting from exposure of the first resin film and the filler layer to water vapor or the like. Consequently, the quantity of light incident upon the solar cells through the first resin film and the filler layer can be inhibited from reduction, whereby the quantity of power generation of the solar cell module can be inhibited from reduction.

In the aforementioned method of manufacturing a solar cell module according to the second aspect, the gas barrier layer preferably includes an aluminum oxide layer. According to this structure, the first resin film, the filler layer and the solar cells can be easily inhibited from exposure to water vapor or the like since the aluminum oxide layer suppresses gas permeation.

In the aforementioned method of manufacturing a solar cell module according to the second aspect, at least one of the adhesive film and the second resin film preferably contains an ultraviolet absorber. According to this structure, the first resin film arranged inside the adhesive film and the filler layer arranged inside the first resin film can be inhibited from irradiation with ultraviolet light also when ultraviolet light included in sunlight is irradiated to the laminated resin film, whereby the first resin film and the filler layer can be inhibited from discoloring with ultraviolet light. Thus, the quantity of light incident upon the solar cells from the side of the adhesive film and the weather-resistant second resin film can be inhibited from reduction. Consequently, the quantity of power generation of the solar cell module can be inhibited from reduction also when ultraviolet light is irradiated.

In the aforementioned method of manufacturing a solar cell module according to the second aspect, the solar cells are preferably of a double-incidence type. When the aforementioned first resin film, the adhesive film and the second resin film are laminated on the side of at least either surfaces of the double-incidence type solar cells, the quantity of power generation can be inhibited from reduction and the adhesive strength of the laminated resin film can be retained also when the solar cell module is exposed to environment influenced by heat, moisture, light (ultraviolet light) etc. over a long period, while obtaining a solar cell module having a larger quantity of power generation as compared with a solar cell module employing single-incidence type solar cells.

In the aforementioned method of manufacturing a solar cell module according to the second aspect, the first resin film preferably contains polyethylene terephthalate (PET). According to this structure, the first resin film can be inhibited from discoloring or deterioration since the first resin film containing polyethylene terephthalate (PET) has heat resistance, an insulation property and transparency also when exposed to environment influenced by heat, moisture, light (ultraviolet light) etc. over a long period.

In the aforementioned method of manufacturing a solar cell module according to the second aspect, the second resin film having weather resistance preferably contains polyvinylidene fluoride (PVDF). According to this structure, the second resin film can be inhibited from discoloring or deterioration since the weather-resistant second resin film containing polyvinylidene fluoride (PVDF) has weather resistance, water resistance, light resistance, abrasion resistance and transparency also when exposed to environment influenced by heat, moisture, light (ultraviolet light) etc. over a long period.

In the aforementioned method of manufacturing a solar cell module according to the second aspect, the step of performing integration by carrying out heating/pressure-bonding preferably includes a step of performing integration by carrying out heating/pressure-bonding in a state successively arranging the first resin film, the adhesive film and the second resin film on one surface of the filler layer while arranging a glass plate on another surface of the filler layer. According to this structure, it is possible to efficiently generate power with sunlight incident from the side of the glass plate by arranging the glass plate having high light transmittance to be on the side of the sunlight while arranging the first resin film, the adhesive film an the second resin film having smaller light transmittance than the glass plate to be on a side opposite to the side of the sunlight. Consequently, the quantity of power generation of the solar cell module can be increased as compared with a case of arranging first resin films, adhesive films and second resin films on both surfaces of the filler layer sealing the solar cells.

### Brief Description of the Drawings

[Fig. 1] A sectional view showing the structure of a solar cell module according to Example 1 prepared according to the present invention.
[Fig. 2] A sectional view of a solar cell of the solar cell module according to Example 1 shown in Fig. 1.
[Fig. 3] A sectional view of a resin film before carrying out heat treatment of the solar cell module according to Example 1 shown in Fig. 1.
[Fig. 4] An exploded view for illustrating a preparation process for the solar cell module according to Example 1 shown in Fig. 1.
[Fig. 5] A sectional view showing the structure of a solar cell module according to Example 2 prepared according to the present invention.
[Fig. 6] A sectional view showing the structure of a solar cell module according to Example 3 prepared according to the present invention.
[Fig. 7] A sectional view of an exemplary conventional double-sided generation type solar cell module holding solar cells sealed with a filler between two glass plates.
[Fig. 8] A sectional view of an exemplary conventional double-sided solar cell module employing surface protectors consisting of resin films.

### Best Modes for Carrying Out the Invention

Examples of the present invention are now described with reference to the drawings.

### (Example 1)

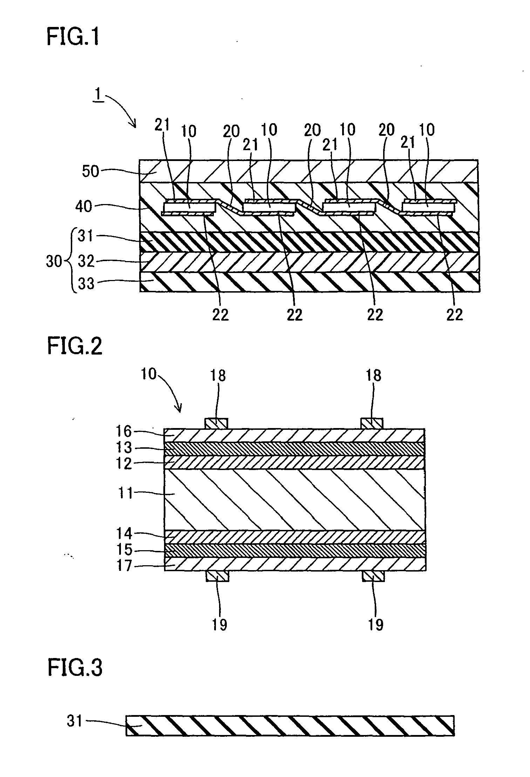

A solar cell module 1 comprises a plurality of solar cells 10 (see Fig. 2) as shown in Fig. 1, and each of these plurality of solar cells 10 is connected to another solar cell 10 adjacent thereto through a tab electrode 20 consisting of copper foil. The solar cells 10 connected with each other through the tab electrodes 20 are sealed with a filler 40 consisting of EVA (Ethylene Vinyl Acetate: ethylene vinyl acetate) resin having a thickness of about 1.2 mm. A surface protector 50 consisting of white glass for surface protection is provided on the upper surface of the filler 40 sealing the plurality of solar cells 10.

Each solar cell 10 is a double-incidence type solar cell, as shown in Fig. 2. The solar cell 10 has an n-type single-crystalline Si substrate 11, and an i-type amorphous Si layer 12 and a p-type amorphous Si layer 13 are successively laminated on the upper surface of the n-type single-crystalline Si substrate 11. A transparent conductive film 16 consisting of ITO (Indium Tin Oxide: indium tin oxide) is formed on the upper surface of the p-type amorphous Si layer 13, while comb-shaped collector electrodes 18 consisting of Ag are formed on prescribed regions of the transparent conductive film 16. Another i-type amorphous Si layer 14 and an n-type amorphous Si layer 15 are successively laminated on the lower surface of the n-type single-crystalline Si substrate 11. Another transparent conductive film 17 of ITO is formed on the lower surface of the n-type amorphous Si layer 15, while comb-shaped collector electrodes 19 consisting of Ag are formed on prescribed regions of the transparent conductive film 17.

According to Example 1, a laminated resin film 30 is provided on the lower surface of the filler 40 sealing the plurality of solar cells 10. In this laminated resin film 30, a resin film 31 consisting of a PET sheet, an adhesive film 32 consisting of a copolymer of α-olefin and an ethyleny unsaturated silane compound and a weather-resistant resin film 33 consisting of PVDF resin are laminated successively from the side of the solar cells 10. The resin film 31 is an example of the "first resin film" in the present invention, and the weather-resistant resin film 33 is an example of the "second resin film" in the present invention. A benzophenone-based ultraviolet absorber is contained in the weather-resistant resin film 33.

A preparation process for the solar cell module 1 according to the aforementioned Example 1 is described with reference to Figs. 1 to 4.

### [Preparation of Solar Cell Module]

First, the n-type single-crystalline Si substrate 11 was prepared as shown in Fig. 2. Then, the i-type amorphous Si layer 12 having a thickness of 10 nm and the p-type amorphous Si layer 13 having a thickness of 10 nm were successively formed on the upper surface of the n-type single-crystalline Si substrate 11 by RF plasma CVD.

Then, the i-type amorphous Si layer 14 having a thickness of 10 nm and the n-type amorphous Si layer 15 having a thickness of 10 nm were successively formed on the lower surface of the n-type single-crystalline Si substrate 11 by RF plasma CVD.

The transparent conductive films 16 and 17 of ITO having thicknesses of about 100 nm were formed on the respective ones of the p-type amorphous Si layer 13 and the n-type amorphous Si layer 15 respectively by magnetron sputtering.

Then, the comb-shaped collector electrodes 18 and 19 consisting of Ag were formed on the prescribed regions of the respective ones of the upper surface of the transparent conductive film 16 and the lower surface of the transparent conductive film 17 respectively by screen printing. Thus, the square-shaped double-incidence type solar cells 10 each having a thickness of about 200 µm and a length of 125 mm of each side were prepared in plural.

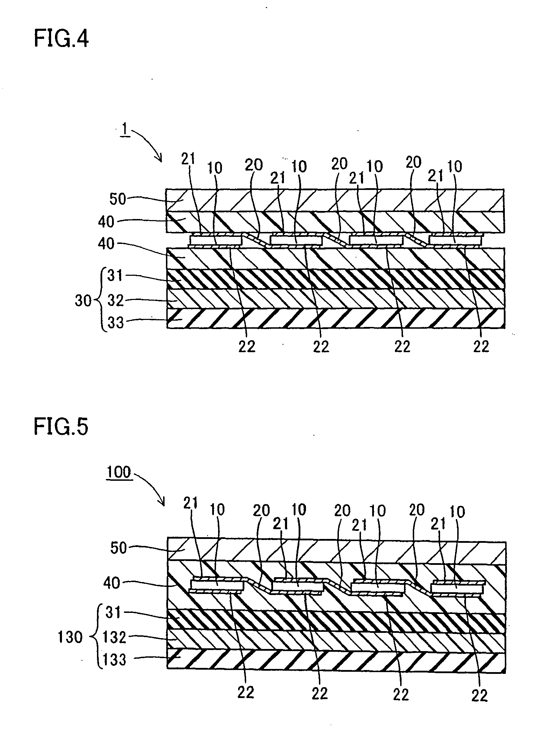

Then, the sides of first ends 21 of the tab electrodes 20 consisting of copper foil were connected to the collectors 18 (see Fig. 2) on the upper surface sides (sides of the p-type amorphous Si layers 13) of the plurality of solar cells 10 prepared in the aforementioned manner, as shown in Fig. 4. The sides of second ends 22 of the tab electrodes 20 were connected to the collectors 19 (see Fig. 2) on the lower surface sides (sides of the n-type amorphous Si layers 15) of other different adjacent solar cells 10. Thus, the plurality of solar cells 10 were serially connected with each other.

As shown in Fig. 3, the resin film 31 consisting of the PET sheet having a thickness of 12 µm was prepared, and this resin film 31 was previously thermally shrank by heat-treating the same at 150°C for 30 minutes. Thus, the resin film 31, subjected to the heat treatment, having a thermal shrinkage factor of not more than 1.0 %, preferably not more than 0.3 %, was formed. Then, the adhesive film 32 consisting of the copolymer of α-olefin and the ethyleny unsaturated silane compound and having a thickness of about 200 µm and the weather-resistant resin film 33 consisting of PVDF resin having a thickness of 20 µm were prepared as shown in Fig. 4. The weather-resistant resin film 33 was made to contain the benzophenone-based ultraviolet absorber. The adhesive film 32 and the previously thermally shrank resin film 31 were successively laminated on the weather-resistant resin film 33. The resin film 31, the adhesive film 32 and the weather-resistant resin film 33 laminated in this manner are pressure-bonded to each other in a later heating/pressure-bonding step, to form the laminated resin film 30.

Then, the filler 40 consisting of EVA resin was placed on the resin film 31 among the resin film 31, the adhesive film 32 and the weather-resistant resin film 33 laminated in the aforementioned manner, and thereafter the plurality of solar cells 10 connected with each other through the tab electrodes 20 were placed. Another filler 40 consisting of EVA resin was further placed thereon, and thereafter the surface protector 50 consisting of the white glass having a thickness of 3.2 mm was placed. The filler 40 is an example of the "filler layer" in the present invention, and the surface protector 50 consisting of the white glass is an example of the "glass plate" in the present invention. Thus, the surface protector 50 consisting of the white glass was arranged on the sides of the p-type amorphous Si layers 13 (see Fig. 2) of the solar cells 10, while the laminated resin film 30 was arranged on the sides of the n-type amorphous Si layers 15 (see Fig. 2). Thereafter heating/pressure-bonding was performed at 150°C for about 15 minutes to about 60 minutes, thereby forming the laminated resin film 30 consisting of the resin film 31, the adhesive film 32 and the weather-resistant resin film 33, while integrating the surface protector 50, the upper filler 40, the plurality of solar cells 10 connected with each other through the tab electrodes 20, the lower filler 40 and the laminated resin film 30 with each other. The double-sided generation type solar cell module 1 according to Example 1 shown in Fig. 1 was prepared in this manner.

### (Example 2)

Referring to Fig. 5, an adhesive film 132 consisting of a copolymer of α-olefin and an ethyleny unsaturated silane compound was made to contain a benzophenone-based ultraviolet absorber while a weather-resistant resin film 133 consisting of PVDF resin containing no benzophenone-based ultraviolet absorber was prepared in this Example 2, dissimilarly to the aforementioned Example 1. Then, a laminated resin film 130 consisting of a resin film 31, the adhesive film 132 and the weather-resistant resin film 133 was prepared. The weather-resistant film 133 is an example of the "second resin film" in the present invention. A solar cell module 100 according to Example 2 was prepared under similar preparation conditions to the aforementioned Example 1, except this.

### (Example 3)

Referring to Fig. 6, a resin film 231 was constituted of a substrate film 231a consisting of PET resin having a thickness of 12 µm and a gas barrier layer 231b formed by evaporating aluminum oxide having a thickness of about 100 nm onto the lower surface of the substrate film 231a in this Example 3, dissimilarly to the aforementioned Example 1. According to Example 3, further, an adhesive film 232 consisting of a copolymer of α-olefin and an ethyleny unsaturated silane compound containing a benzophenone-based ultraviolet absorber and a weather-resistant resin film 233 consisting of PVDF resin containing no benzophenone-based ultraviolet absorber were prepared, similarly to the aforementioned Example 2. Then, a laminated resin film 230 consisting of the resin film 231, the adhesive film 232 and the weather-resistant resin film 233 was prepared. The resin film 231 is an example of the "first resin film" in the present invention, and the weather-resistant resin film 233 is an example of the "second resin film" in the present invention. A solar cell module 200 according to Example 3 was prepared under similar preparation conditions to the aforementioned Example 1, except this.

### (Comparative Example 1)

In this comparative example 1, a structure corresponding to the conventional double-sided generation type solar cell module 400 shown in Fig. 8 was prepared. In other words, a laminated resin film 440 in which a PET film 441 and a PVDF film 442 containing a benzophenone-based ultraviolet absorber were bonded to each other with an adhesive was prepared in this comparative example 1. In comparative example 1, further, no thermal shrinkage of the PET film 441 corresponding to the thermal shrinkage of the resin films 31 and 231 performed in advance of the heating/pressure-bonding steps in Examples 1 to 3 was carried out. A solar cell module 400 according to comparative example 1 was prepared under similar preparation conditions to the aforementioned Example 1, except the laminated resin film 440.

### [Constant Temperature/Constant Humidity Test]

Then, a constant temperature/constant humidity test was conducted as to the solar cell modules 1, 100 and 200 according to Examples 1 to 3 and the solar cell module 400 according to comparative example 1 prepared in the aforementioned manner. More specifically, initial outputs of the solar cell modules 1, 100, 200 and 400 under photoirradiation were first measured. Thereafter the solar cell modules 1, 100, 200 and 400 were set under environment kept at a temperature of 85°C and humidity of 85 % for 2000 hours. Then, outputs of the solar cell modules 1, 100, 200 and 400 under photoirradiation after a lapse of 2000 hours were measured. The initial outputs and the outputs after the lapse of 2000 hours were measured by irradiating light from the sides of the laminated resin films 30, 130, 230 and 440 with a solar simulator. Then, the ratios (hereinafter referred to as output ratios in the constant temperature/constant humidity test) of the outputs after the lapse of 2000 hours to the initial outputs of the solar cell modules 1, 100, 200 and 400 were calculated. Then, output retention ratios (normalized values) were calculated by normalizing the output ratios of the solar cell modules 1, 100 and 200 according to Examples 1 to 3 in the constant temperature/constant humidity test assuming that an output ratio in the constant temperature/constant humidity test calculated with the solar cell module 400 according to comparative example 1 was 1. The following Table 1 shows the results of the aforementioned constant temperature/constant humidity test. Temperature resistance/humidity resistance values (output retention characteristics with respect to heat and water) of the solar cell modules 1, 100 and 200 according to Examples 1 to 3 were evaluated through the output retention ratios (normalized values) in Table 1.

**[Table 1]**

| Constant Temperature/ Constant Humidity Test | Example 1 | Example 2 | Example 3 | Comparative Example 1 |
|---|---|---|---|---|
| Output Retention Ratio (Normalized Value) | 1.09 | 1.08 | 1.18 | 1.00 |

From the above Table 1, it is understood that the output retention ratios (normalized values) (1.09, 1.08 and 1.18) of the solar cell modules 1, 100 and 200 according to Examples 1 to 3 in the constant temperature/constant humidity test are larger as compared with the output retention ratio (normalized value) (1.00) of the solar cell module 400 according to comparative example 1 in the constant temperature/constant humidity test. This is conceivably for the following reason: In other words, the output ratio in the constant temperature/constant humidity test conceivably decreased in comparative example 1 since an adhesive for bonding the PET film 441 and the PVDF film 442 according to comparative example 1 to each other was discolored due to the constant temperature/constant humidity test. On the other hand, the output ratios of Examples 1 to 3 in the constant temperature/constant humidity test conceivably increased as compared with the output ratio of comparative example 1 in the constant temperature/constant humidity test since the adhesive films 32, 132 and 232 consisting of the copolymers of α-olefin and the ethyleny unsaturated silane compounds for bonding the resin films 31 and 231 and the weather-resistant resin films 33, 133 and 233 according to Examples 1 to 3 to each other were less discolored also in the constant temperature/constant humidity test. Further, it is understood that the output retention ratio (normalized value) (1.18) of the solar cell module 200 according to Example 3 is larger as compared with the output retention ratios (normalized values) (1.09 and 1.08) of the solar cell modules 1 and 100 according to Examples 1 and 2. This is conceivably for the following reason: In other words, the resin film 231 or the filler 40 was conceivably less discolored since the gas barrier layer 231b consisting of aluminum oxide evaporated onto the substrate film 231a of the resin film 231 of the laminated resin film 230 according to Example 3 suppressed external infiltration of water vapor.

### [Ultraviolet Irradiation Test]

Then, an ultraviolet irradiation test was conducted as to the solar cell modules 1, 100 and 200 according to Examples 1 to 3 and the solar cell module 400 according to comparative example 1 prepared in the aforementioned manner. More specifically, initial outputs of the solar cell modules 1, 100, 200 and 400 under photoirradiation were first measured. Thereafter ultraviolet light was irradiated from the sides of the laminated resin films 30, 130, 230 and 440 of the solar cell modules for 24 hours. Thereafter outputs of the solar cell modules 1, 100, 200 and 400 irradiated with the ultraviolet light for 24 hours under photoirradiation were measured. The initial outputs and the outputs after the lapse of 24 hours were measured by irradiating light from the sides of the laminated resin films 30, 130, 230 and 440 with a solar simulator. The ratios (hereinafter referred to as output ratios in the ultraviolet irradiation test) of the outputs after the lapse of 24 hours to the initial outputs of the solar cell modules 1, 100, 200 and 400 were calculated. Then, output retention ratios (normalized values) were calculated by normalizing the output ratios of the solar cell modules 1, 100 and 200 according to Examples 1 to 3 in the ultraviolet irradiation test assuming that an output ratio in the ultraviolet irradiation test calculated with the solar cell module 400 according to comparative example 1 was 1. The following Table 2 shows the results of the aforementioned ultraviolet irradiation test. Ultraviolet resistance values (output retention characteristics with respect to ultraviolet light (sunlight)) of the solar cell modules 1, 100 and 200 according to Examples 1 to 3 were evaluated through the output retention ratios (normalized values) in Table 2.

**[Table 2]**

| Ultraviolet Irradiation Test | Example 1 | Example 2 | Example 3 | Comparative Example 1 |
|---|---|---|---|---|
| Output Retention Ratio (Normalized Value) | 1.001 | 1.001 | 1.002 | 1.000 |

From the above Table 2, it is understood that the output retention ratios (normalized values) (1.001, 1.001 and 1.002) of the solar cell modules 1, 100 and 200 according to Examples 1 to 3 in the ultraviolet irradiation test are substantially at the same degrees as compared with the output retention ratio (normalized value) (1.000) of the solar cell module 400 according to comparative example 1 in the ultraviolet irradiation test. Thus, ultraviolet light can conceivably be absorbed whichever layers of the laminated resin films 30, 130, 230 and 440 are made to contain ultraviolet absorbers.

### [Bond Strength Test]

Then, a bond strength was conducted as to the solar cell modules 1, 100 and 200 according to Examples 1 to 3 and the solar cell module 400 according to comparative example 1 prepared in the aforementioned manner. More specifically, the solar cell modules 1, 100, 200 and 400 were set under environment kept at a temperature of 85°C and humidity of 85 % for 2000 hours, similarly to the aforementioned constant temperature/constant humidity test. Then, notches of 15 mm in width were formed in the laminated resin films 30, 130, 230 and 440 of the solar cell modules 1, 100, 200 and 400. As to Example 1, peeling was performed at a peel rate of 50 mm/min. in a direction of 90° on the interface between the weather-resistant resin film 33 and the adhesive film 32 and on the interface between the adhesive film 32 and the resin film 31, for measuring peel strength. As to Example 2, peeling was performed at a peel rate of 50 mm/min. in a direction of 90° on the interface between the weather-resistant resin film 133 and the adhesive film 132 and on the interface between the adhesive film 132 and the resin film 31, for measuring peel strength. As to Example 3, peeling was performed at a peel rate of 50 mm/min. in a direction of 90° on the interface between the weather-resistant resin film 233 and the adhesive film 232 and on the interface between the adhesive film 232 and the resin film 231, for measuring peel strength. As to comparative example 1, peeling was performed at a peel rate of 50 mm/min. in a direction of 90° on the interface between the PET film 441 and the PVDF film 442, for measuring peel strength. Bond strength values (normalized values) were calculated by normalizing the peel strength values of the laminated resin films 30, 130 and 230 of the solar cell modules 1, 100 and 200 according to Examples 1 to 3 assuming that the peel strength of the laminated resin film 440 of the solar cell module 400 according to comparative example 1 was 1. The following Table 3 shows the results of the aforementioned bond strength test. The bond strength values (peel strength retention characteristics with respect to heat and water) of the solar cell modules 1, 100 and 200 according to Examples 1 to 3 were evaluated.

**[Table 3]**

| | Example 1 | Example 2 | Example 3 | Comparative Example 1 |
|---|---|---|---|---|
| Bond Strength (Normalized Value) | Weather-Resistant Resin Film/ Adhesive Film | Weather-Resistant Resin Film/ Adhesive Film | Weather-Resistant Resin Film/ Adhesive Film | PVDF Film /PET Film |
| | 2. 35 | 2. 25 | 2.28 | |
| | Adhesive Film/ Resin Film | Adhesive Film/ Resin Film | Adhesive Film/ Resin Film | 1.00 |
| | 2.28 | 2.31 | 2.12 | |

From the above Table 3, it is understood that all of the bond strength (normalized value) (2.35) of the weather-resistant resin film 33 and the adhesive film 32 according to Example 1, the bond strength (normalized value) (2.28) of the adhesive film 32 and the resin film 31 according to Example 1, the bond strength (normalized value) (2.25) of the weather-resistant resin film 133 and the adhesive film 132 according to Example 2, the bond strength (normalized value) (2.31) of the adhesive film 132 and the resin film 31 according to Example 2, the bond strength (normalized value) (2.28) of the weather-resistant resin film 233 and the adhesive film 232 according to Example 3 and the bond strength (normalized value) (2.12) of the adhesive film 232 and the resin film 231 according to Example 3 are larger than the bond strength (normalized value) (1.00) of the PET film 441 and the PVDF film 442 according to comparative example 1. This is conceivably for the following reason: In other words, the bond strength (normalized value) of comparative example 1 conceivably decreased as compared with the bond strength values (normalized values) of Examples 1 to 3 since the adhesive for bonding the PET film 441 and the PVDF film 442 according to comparative example 1 to each other was deteriorated due to the constant temperature/constant humidity test. On the other hand, the bond strength values (normalized values) of Examples 1 to 3 conceivably increased as compared with the normalized bond strength (normalized value) of comparative example 1 since the degrees of deterioration were small also in the constant temperature/constant humidity test in the adhesive films 32, 132 and 232 consisting of the copolymers of α-olefin and the ethyleny unsaturated silane compounds according to Examples 1 to 3.

According to Examples 1 to 3, as hereinabove described, the laminated resin films 30, 130 and 230 in which the resin films 31 and 231 consisting of PET resin, the adhesive films 32, 132 and 232 consisting of the copolymers of α-olefin and the ethyleny unsaturated silane compounds and the weather-resistant resin films 33, 133 and 233 are laminated successively from the sides of the solar cells 10 are so provided that the adhesive films 32, 132 and 232 bonding the resin films 31 and 231 and the weather-resistant resin films 33, 133 and 233 to each other can be inhibited from discoloring resulting from exposure to environment influenced by heat (temperature), moisture (humidity) etc. over a long period (2000 hours) since the adhesive films 32, 132 and 232 consisting of the copolymers of α-olefin and the ethyleny unsaturated silane compounds are less discolored also when set under environment kept at a temperature of 85°C and humidity of 85 % for 2000 hours. Thus, the quantities of light incident upon the solar cells 10 through the adhesive films 32, 132 and 232 can be inhibited from reduction. Consequently, the quantities of power generation of the solar cell modules 1, 100 and 200 can be inhibited from reduction also when the solar cell modules are set under environment kept at a temperature of 85°C and humidity of 85 % for 2000 hours.

According to Examples 1 to 3, further, the adhesive films 32, 132 and 232 consisting of the copolymers of α-olefin and the ethyleny unsaturated silane compounds are so employed that the adhesive films 32, 132 and 232 can be inhibited from deterioration resulting from arrangement under environment influenced by ultraviolet light for 24 hours, whereby the adhesive strength values of the adhesive films 32, 132 and 232 can be inhibited from reduction. Consequently, the adhesive strength values of the adhesive films 32, 132 and 232 can be retained also when the adhesive films are arranged under environment influenced by ultraviolet light for 24 hours, whereby peeling between the resin films 31 and 231 and the weather-resistant resin films 33, 133 and 233 can be suppressed.

According to Examples 1 to 3, in addition, the resin films 31 and 231 closest to the sides of the solar cells 10 among the resin films 31 and 231, the adhesive films 32, 132 and 232 and the weather-resistant resin films 33, 133 and 233 can be inhibited from thermally shrinking again in heating/pressure-bonding at 150°C for about 15 minutes to about 60 minutes by heat-treating the resin films 31 and 231 consisting of PET sheets at 150°C for 30 minutes before carrying out heating/pressure-bonding thereby previously thermally shrinking the resin films 31 and 231. Thus, the solar cells 10 can be inhibited from moving following thermal shrinkage of the resin films 31 and 231 in heating/pressure-bonding, whereby the plurality of solar cells 10 can be inhibited from coming into contact with each other. Consequently, the solar cells 10 can be inhibited from breakage.

Examples disclosed this time must be considered as illustrative and not restrictive in all points. The range of the present invention is shown not by the above description of Examples but by the scope of claim for patent, and all modifications within the meaning and range equivalent to the scope of claim for patent are further included.

For example, while the examples employing the copolymers of α-olefin and the ethyleny unsaturated silane compounds as the adhesive films have been shown in the aforementioned Examples 1 to 3, the present invention is not restricted to this but an adhesive film consisting of a copolymer of denatured α-olefin and an ethyleny unsaturated silane compound may be employed, or an adhesive film consisting of a condensate of α-olefin and an ethyleny unsaturated silane compound may be employed.

While the examples employing the adhesive films consisting of the copolymers of α-olefin and the ethyleny unsaturated silane compounds have been shown in the aforementioned Examples 1 to 3, the present invention is not restricted to this but a copolymer prepared by making a copolymer of α-olefin and an ethyleny unsaturated silane compound contain vinyl acetate, acrylic acid, methacrylic acid, methyl acrylate, methyl methacrylate, ethyl acrylate or vinyl alcohol is also employable.

While the examples employing PET resin as the resin films of the laminated resin films have been shown in the aforementioned Examples 1 to 3, the present invention is not restricted to this but a resin film consisting of another resin material may be used so far as the same is a resin film having heat resistance, an insulation property and transparency.

While the examples employing PVDF resin as the weather-resistant resin films of the laminated resin films have been shown in the aforementioned Examples 1 to 3, the present invention is not restricted to this but the resin film may be selected from resin films of fluororesin, polyester resin etc. other than PVDF resin having at least weather resistance, heat resistance, water resistance, light resistance, rub resistance and transparency to be used.

While the aforementioned Examples 1 to 3 have been described with reference to the solar cell modules employing the solar cells prepared by successively forming the i-type amorphous Si layers and the p-type amorphous Si layers on the upper surfaces of the n-type single-crystalline Si substrates while successively forming the i-type amorphous Si layers and the n-type amorphous Si layers on the lower surfaces of the n-type single-crystalline Si substrates, the present invention is not restricted to this but the present invention is applicable as to a solar cell module employing various solar cells such as single-crystalline Si solar cells, polycrystalline Si solar cells, amorphous Si solar cells, microcrystalline Si solar cells, compound solar cells, dye-sensitized solar cells or hybrid solar cells thereof.

While the examples employing white glass as the first surface protectors have been described in the aforementioned Examples 1 to 3, the present invention is not restricted to this but a surface protector consisting of another glass such as tempered glass or float glass may be employed.

While the examples employing EVA as the fillers for sealing the solar cells have been described in the aforementioned Examples 1 to 3, the present invention is not restricted to this but fluororesin, an ethylene-vinyl acetate copolymer, ionomer resin, an ethylene-acrylic acid copolymer, a methacrylic acid copolymer, polyethylene resin, polypropylene resin, denatured polyolefin resin prepared by denaturing polyolefin resin such as polyethylene resin or polypropylene resin with unsaturated carboxylic acid such as acrylic acid, itaconic acid, mailec acid or fumaric acid, polyvinyl butyral resin, silicone resin, epoxy resin or (meth)acrylic resin may be employed, or a mixture of the aforementioned resin materials may be employed. In this case, additives such as a crosslinking agent, a thermal oxidation inhibitor, a light stabilizer, an ultraviolet absorber, a photooxidation inhibitor and a coupling agent may be arbitrarily added to and mixed into the resin employed as the filler for sealing the solar cells in the range improving weather resistance such as heat resistance, light resistance and water resistance and not losing transparency.

The thicknesses of the surface protector, the filler, the resin film, the adhesive film and the weather-resistant resin film are not restricted to the ranges of the description of Examples 1 to 3 but can be properly set in consideration of weather resistance, heat resistance, water resistance, light resistance, abrasion resistance, a gas barrier property, mechanical strength, an insulation property, durability and transparency.

While the examples carrying out heating/pressure-bonding at 150°C for about 15 minutes to about 60 minutes in the manufacturing processes for the solar cell modules have been shown in the aforementioned Examples 1 to 3, the present invention is not restricted to this but the conditions for manufacturing the solar cell module may be changed.

While the examples employing the adhesive films or the weather-resistant resin films containing the benzophenone-based ultraviolet absorbers have been shown in the aforementioned Examples 1 to 3, the present invention is not restricted to this but an adhesive film or a weather-resistant resin film containing an ultraviolet absorber consisting of a benzoate-based, triazol-based, triazine-based, salicylic acid derivative-based or acrylonitrile derivative-based organic compound or inorganic particulates of titanium oxide or zinc oxide may be employed.

While the example forming the gas barrier layer prepared by evaporating aluminum oxide onto the substrate film of the resin film has been shown in the aforementioned Example 3, the present invention is not restricted to this but a gas barrier layer prepared by evaporating silicon oxide (SiO₂) or the like onto the substrate film of the resin film may be formed.

## Claims

1. A solar cell module comprising:
a plurality of solar cells (10) electrically connected with each other;
a filler layer (40) for sealing said plurality of solar cells; and
a laminated resin film (30, 130, 230), arranged on at least one surface of said filler layer, in which a first resin film (31, 231), an adhesive film (32, 132, 232) consisting of resin containing α-olefin and an ethyleny unsaturated silane compound and a second resin film (33, 133, 233) having weather resistance are laminated successively from the side of said solar cells.

2. The solar cell module according to claim 1, wherein
the adhesive film of said laminated resin film contains a copolymer of said α-olefin and the ethyleny unsaturated silane compound.

3. The solar cell module according to claim 1, wherein
the first resin film of said laminated resin film includes a substrate film (231a) and a gas barrier layer (231b), and
said gas barrier layer is arranged at least on a side of said substrate film closer to said adhesive film.

4. The solar cell module according to claim 3, wherein
said gas barrier layer includes an aluminum oxide layer.

5. The solar cell module according to claim 1, wherein
at least one of the adhesive film and the second resin film of said laminated resin film contains an ultraviolet absorber.

6. The solar cell module according to claim 1, wherein
said solar cells are of a double-incidence type.

7. The solar cell module according to claim 1, wherein
the first resin film of said laminated resin film contains polyethylene terephthalate.

8. The solar cell module according to claim 1, wherein
the second resin film, having weather resistance, of said laminated resin film contains polyvinylidene fluoride.

9. The solar cell module according to claim 1, wherein
said laminated resin film is arranged on one surface of said filler layer, and
a glass plate (50) is arranged on another surface of said filler layer.

10. A method of manufacturing a solar cell module, comprising steps of:
preparing a plurality of solar cells (10) electrically connected with each other;
heat-treating a first resin film (31, 231) thereby previously thermally shrinking said first resin film; and
thereafter integrating said plurality of solar cells, a filler layer (40), said first resin film, an adhesive film (32, 132, 232) consisting of resin containing α-olefin and an ethyleny unsaturated silane compound and a second resin film (33, 133, 233) having weather resistance by performing heating/pressure-bonding in a laminated state.

11. The method of manufacturing a solar cell module according to claim 10, wherein
said step of previously thermally shrinking said first resin film
includes a step of previously thermally shrinking said first resin film under a temperature condition substantially identical to a temperature condition for said step of performing integration by carrying out heating/pressure-bonding.

12. The method of manufacturing a solar cell module according to claim 10, wherein
said adhesive film contains a copolymer of said α-olefin and the ethyleny unsaturated silane compound.

13. The method of manufacturing a solar cell module according to claim 10, wherein
said first resin film includes a substrate film (231a) and a gas barrier layer (231b), and
said gas barrier layer is arranged at least on a side of said substrate film closer to said adhesive film.

14. The method of manufacturing a solar cell module according to claim 13, wherein
said gas barrier layer includes an aluminum oxide layer.

15. The method of manufacturing a solar cell module according to claim 10, wherein
at least one of said adhesive film and the second resin film contains an ultraviolet absorber.

16. The method of manufacturing a solar cell module according to claim 10, wherein
said solar cells are of a double-incidence type.

17. The method of manufacturing a solar cell module according to claim 10, wherein
said first resin film contains polyethylene terephthalate.

18. The method of manufacturing a solar cell module according to claim 10, wherein
said second resin film having weather resistance contains polyvinylidene fluoride.

19. The method of manufacturing a solar cell module according to claim 10, wherein
said step of performing integration by carrying out heating/pressure-bonding
includes a step of performing integration by carrying out heating/pressure-bonding in a state successively arranging said first resin film, said adhesive film and said second resin film on one surface of said filler layer while arranging a glass plate (50) on another surface of said filler layer.
